# EUROPEAN PATENT APPLICATION

(11) **EP 4 498 405 A1**
(43) Date of publication of application: **29.01.2025**
(21) Application number: 22933654.0
(22) Date of filing: 12.12.2022
(51) Int. Cl.: H01L 21/306

(54) **LEARNING DEVICE, INFORMATION PROCESSING DEVICE, SUBSTRATE PROCESSING DEVICE, SUBSTRATE PROCESSING SYSTEM, LEARNING METHOD, AND PROCESSING CONDITIONS DETERMINATION METHOD**

(30) Priority: 23.03.2022 JP 2022047203
(71) Applicant: SCREEN Holdings Co., Ltd., Kyoto-shi, Kyoto 602-8585 (JP)
(72) Inventor: TOKUYAMA, Masahiro, Kyoto-shi, Kyoto 602-8585 (JP)
(74) Representative: Goddar, Heinz J.
(86) International application number: PCT/JP2022/045709
(87) International publication number: WO 2023/181525

(57) **Abstract**

A training device includes an experimental data acquirer that acquires a processing amount indicating a difference between a film thickness obtained before a process and a film thickness obtained after the process in regard to a film formed on a substrate, after a substrate processing apparatus is driven according to processing conditions including a variable condition that varies over time, a first compressor that converts the variable condition such that a dimension count is reduced, and a predictor generator that generates a learning model, which executes machine learning using training data and predicts a processing amount indicating a difference between a film thickness obtained before a process and a film thickness obtained after the process, with the training data including a conversion result of the variable condition converted by the compression device, and the processing amount corresponding to the processing conditions.

## Description

### [Technical Field]

The present invention relates to a training device, an information processing apparatus, a substrate processing apparatus, a substrate processing system, a training method and a processing condition determining method. In particular, the present invention relates to a training device that generates a learning model for simulating a process executed by a substrate processing apparatus according to processing conditions, an information processing apparatus that determines processing conditions using the learning model, a substrate processing apparatus including the information processing apparatus, a training method executed by the training device, and a processing condition determining method executed by the information processing apparatus.

### [Background Art]

In a semiconductor manufacturing process, there is a cleaning process. In the cleaning process, the thickness of a film formed on a substrate is adjusted by an etching process of applying a chemical liquid to the substrate. In this film-thickness adjustment, it is important to execute the etching process such that the surface of the substrate is uniform, or to flatten the surface of the substrate using the etching process. In a case in which an etching liquid is discharged from a nozzle to a portion of the substrate, a nozzle is required to be moved in a radial direction with respect to the substrate. However, the etching process is a complicated process in which a processing amount indicating how much a film is processed changes due to differences in work of moving a nozzle. Further, the processing amount indicating how much the film is processed in the etching process is provided after the substrate is processed. Therefore, the work of setting the work of moving a nozzle requires trial and error by an engineer. Determination for optimal nozzle work is costly and time consuming.

JP 2021-108367 A describes a device that determines scan speed information based on a target processing amount by using a trained model that has executed machine learning using training data in which "input" is a processing amount (etching amount) and "output" is the scan speed information. With this technique, one scan speed information set is determined based on the target processing amount.

[Patent Document 1]JP 2021-108367 A

### [Summary of Invention]

### [Technical Problem]

On the other hand, it is desired to more sufficiently complicate the work of moving a nozzle. The work of moving a nozzle is time-series data representing a position that changes over time. When the work of moving a nozzle is complicated, the number of sampling intervals increases, and thus the number of dimensions of the time series data increases. In general, when the number of dimensions of training data increases, the number of data sets required for machine learning increases exponentially. Therefore, the number of dimensions of the training data increases, so that it is difficult to optimize a learning model obtained by machine learning. Further, because the etching process is a complicated process, the number of nozzle works suitable for a target processing amount is not limited to one, and the number of nozzle works may be two or more than two.

One object of the present invention is to provide a training device and a substrate processing system suitable for machine learning, for a substrate process, using a condition that changes over time.

Further, another object of the present invention is to provide an information processing apparatus, a substrate processing apparatus, a substrate processing system and a processing condition determining method that enable presentation of a plurality of processing conditions for a processing result of a complicated process of processing a substrate.

### [Solution to Problem]

A training device includes an experimental data acquirer that acquires a processing amount indicating a difference between a film thickness obtained before a process and a film thickness obtained after the process in regard to a film formed on a substrate, after a substrate processing apparatus is driven according to processing conditions including a variable condition that varies over time, with the substrate processing apparatus processing the substrate by supplying a processing liquid to the substrate on which the film is formed, a compression device that converts the variable condition such that a dimension count is reduced, and a model generator that generates a learning model, which executes machine learning using training data and predicts a processing amount indicating a difference between a film thickness obtained before a process and a film thickness obtained after the process in regard to a film formed on a substrate before being processed by the substrate processing apparatus, with the training data including a conversion result of the variable condition converted by the compression device, and the processing amount corresponding to the processing conditions.

According to this aspect, the training data includes a conversion result obtained when a variable condition that varies over time is converted such that the number of dimensions is reduced, and a processing amount. Therefore, the number of dimensions of the training data can be reduced. As a result, it is possible to provide the training device suitable for machine learning, for a substrate process, using a condition that changes over time.

Preferably, the training device further includes a variable condition generator that generates a plurality of variable conditions, and a compression device generator that causes an autoencoder to learn the plurality of variable conditions generated by the variable condition generator and generates the compression device.

According to this aspect, the compression device is generated when the autoencoder learns variable conditions. This facilitates generation of the compression device.

Preferably, the processing conditions further include a fixed condition that does not vary over time, and the training data includes the fixed condition.

According to this aspect, it is possible to manage a process with different fixed conditions, and it is not necessary to generate a plurality of learning models with different fixed conditions.

Preferably, the training device further includes a record acquirer that acquires a processing amount indicating a difference between a film thickness obtained before a process and a film thickness obtained after the process in regard to a film formed on a substrate processed by the substrate processing apparatus, with the substrate processing apparatus being driven according to processing conditions including a temporary condition in a case in which a conversion result of the temporary variable condition converted by the compression device is provided to the learning model, and a processing amount predicted by the learning model satisfies an allowable condition, and an additional trainer that trains the learning model using additional training data that includes a conversion result of the temporary variable condition converted by the compression device, and the processing amount acquired by the record acquirer.

According to this aspect, because the learning model is additionally trained, it is possible to improve the performance of the learning model.

Preferably, the training device further includes a distillater that, in a case in which a conversion result of a temporary variable condition converted by the compression device is provided to the learning model, and a processing amount predicted by the learning model satisfies an allowable condition, generates a new learning model using distillation data including the conversion result and the processing amount predicted by the learning model.

According to this aspect, it facilitates preparation of data for training a new learning model.

Preferably, the substrate processing apparatus includes a nozzle that supplies the processing liquid to a substrate, and a mover that changes relative positions of the nozzle and a substrate with respect to each other, and the variable condition is relative positions of the nozzle and the substrate changed by the mover.

According to this aspect, the relative positions of the nozzle and the substrate with respect to each other are changed, and a processing liquid is supplied to the substrate from the nozzle, so that a learning model for predicting a processing amount of a film is generated. Therefore, it is possible to generate the learning model that predicts the processing amount in the etching process.

According to another aspect of the present invention, an information processing apparatus that manages a substrate processing apparatus, wherein the substrate processing apparatus processes a substrate by supplying a processing liquid to a substrate on which a film is formed according to processing conditions including a variable condition that varies over time, and includes a second compression device that converts the variable condition such that a dimension count is reduced, and a processing condition determiner that determines processing conditions for driving the substrate processing apparatus by using a learning model that predicts a processing amount indicating a difference between a film thickness obtained before a process and a film thickness obtained after the process in regard to a film formed on a substrate before being processed by the substrate processing apparatus, the learning model is an inference model that has executed machine training using training data, with the training data including a conversion result of a variable condition included in processing conditions according to which the substrate processing apparatus has processed a substrate and converted by a first compression device that is same as the second compression device, and a processing amount indicating a difference between a film thickness obtained before a process and a film thickness obtained after the process in regard to a film formed on the substrate before being processed by the substrate processing apparatus, and the processing condition determiner, in a case in which a conversion result of a temporary variable condition converted by the second compression device is provided to the learning model, and a processing amount predicted by the learning model satisfies an allowable condition, determines processing conditions including the temporary variable condition as processing conditions for driving the substrate processing apparatus.

According to this aspect, in a case in which a conversion result obtained when a temporary variable condition that varies over time is converted is provided to a learning model, and a processing amount predicted by the learning model satisfies an allowable condition, processing conditions including the temporary variable condition are determined as processing conditions for driving the substrate processing apparatus. Therefore, a plurality of temporary variable conditions can be determined for the processing amount that satisfies the allowable condition. As a result, it is possible to provide the information processing apparatus capable of presenting a plurality of processing conditions for the processing result of a complicated process of processing a substrate.

Preferably, a substrate processing apparatus includes the above-mentioned information processing apparatus.

According to this aspect, it is possible to provide the substrate processing apparatus capable of presenting a plurality of processing conditions for a processing result of a complicated process of processing a substrate.

According to another aspect of the present invention, a substrate processing system that manages a substrate processing apparatus processing a substrate, includes a training device and an information processing apparatus, wherein the substrate processing apparatus processes a substrate by supplying a processing liquid to a substrate on which a film is formed according to processing conditions including a variable condition that varies over time, the training device includes an experimental data acquirer that acquires a processing amount indicating a difference between a film thickness obtained before a process and a film thickness obtained after the process in regard to a film formed on a substrate after the substrate processing apparatus is driven according to the processing conditions, a first compression device converts the variable condition such that a dimension count is reduced, and a model generator that generates a learning model, which executes machine learning using training data and predicts a processing amount indicating a difference between a film thickness obtained before a process and a film thickness obtained after the process in regard to a film formed on a substrate before being processed by the substrate processing apparatus, with the training data including a conversion result of the variable condition converted by the first compression device, and the processing amount corresponding to the processing conditions, the information processing apparatus includes a second compression device that is same as the first compression device, and a processing condition determiner that determines processing conditions for driving the substrate processing apparatus using the learning model generated by the training device, and the processing condition determiner, in a case in which a conversion result of a temporary variable condition converted by the second compression device is provided to the learning model, and a processing amount predicted by the learning model satisfies an allowable condition, determines processing conditions including the temporary variable condition as processing conditions for driving the substrate processing apparatus.

According to this aspect, it is possible to provide the substrate processing system which is suitable for machine learning, for a substrate process, using conditions that change over time, and which can present a plurality of processing conditions for a processing result of a complicated process of processing a substrate.

According to yet another aspect of the present invention, a training method causes a computer to execute a process of acquiring a processing amount indicating a difference between a film thickness obtained before a process and a film thickness obtained after the process in regard to a film formed on a substrate, after a substrate processing apparatus is driven according to processing conditions including a variable condition that varies over time, the substrate processing apparatus processing the substrate by supplying a processing liquid to the substrate on which the film is formed, a compression process of converting the variable condition such that a dimension count is reduced, and a process of generating a learning model, which executes machine learning using training data and predicts a processing amount indicating a difference between a film thickness obtained before a process and a film thickness obtained after the process in regard to a film formed on a substrate before being processed by the substrate processing apparatus, with the training data including a conversion result of the variable condition converted in the compression process, and the processing amount corresponding to the processing conditions.

According to this aspect, it is possible to provide the training method suitable for machine learning, for a substrate process, using a condition that changes over time.

According to another aspect of the present invention, a processing condition determining method is executed by a computer that manages a substrate processing apparatus, wherein the substrate processing apparatus processes a substrate by supplying a processing liquid to a substrate on which a film is formed according to processing conditions including a variable condition that varies over time, the processing condition determining method includes a process of converting the variable condition such that a dimension count is reduced, and a process of determining processing conditions for driving the substrate processing apparatus by using a learning model that predicts a processing amount indicating a difference between a film thickness obtained before a process and a film thickness obtained after the process in regard to a film formed on a substrate before being processed by the substrate processing apparatus, the learning model is an inference model that, in a process same as the process of converting, has executed machine training using training data, with the training data including a conversion result of a variable condition included in processing conditions according to which the substrate processing apparatus has processed a substrate, and a processing amount indicating a difference between a film thickness obtained before a process and a film thickness obtained after the process in regard to a film formed on the substrate before being processed by the substrate processing apparatus, and the process of determining processing conditions includes a process of, in a case in which a conversion result of a temporary variable condition converted in the process of converting is provided to the learning model, and a processing amount predicted by the learning model satisfies an allowable condition, determining processing conditions including the temporary variable condition as processing conditions for driving the substrate processing apparatus.

According to this aspect, it is possible to provide the processing condition determining method with which it is possible to present a plurality of processing conditions for a processing result of a complicated process of processing a substrate.

### [Advantageous Effects of Invention]

It is possible to provide a training device and a substrate processing system suitable for machine learning, for a substrate process, using a condition that changes over time.

Further, it is possible to provide an information processing apparatus, a substrate processing apparatus, a substrate processing system and a processing condition determining method that enable presentation of a plurality of processing conditions for a processing result of a complicated process of processing a substrate.

### [Brief Description of the Drawings]

[FIG. 1] Fig. 1 is a diagram for explaining the configuration of a substrate processing system according to one embodiment of the present invention.
[FIG. 2] Fig. 2 is a diagram showing one example of the configuration of an information processing apparatus.
[FIG. 3] Fig. 3 is a diagram showing one example of the configuration of a training device.
[FIG. 4] Fig. 4 is a diagram showing one example of the functional configuration of a substrate processing system in one embodiment of the present invention.
[FIG. 5] Fig. 5 is a first diagram showing one example of a nozzle work pattern.
[FIG. 6] Fig. 6 is a second diagram showing one example of the nozzle work pattern.
[FIG. 7] Fig. 7 is a diagram showing one example of a film-thickness characteristic.
[FIG. 8] Fig. 8 is a diagram for explaining a prediction device.
[FIG. 9] Fig. 9 is a flowchart showing one example of a flow of an autoencoder generation process.
[FIG. 10] Fig. 10 is a flowchart showing one example of a flow of a prediction device generation process.
[FIG. 11] Fig. 11 is a flowchart showing one example of a flow of a processing condition determination process.
[FIG. 12] Fig. 12 is a flowchart showing one example of a flow of an additional training process.

### [Description of Embodiments]

A substrate processing system according to one embodiment of the present invention will be described below with reference to the drawings. In the following description, a substrate refers to a semiconductor substrate (semiconductor wafer), a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like.

### 1. Overall Configuration of Substrate Processing System

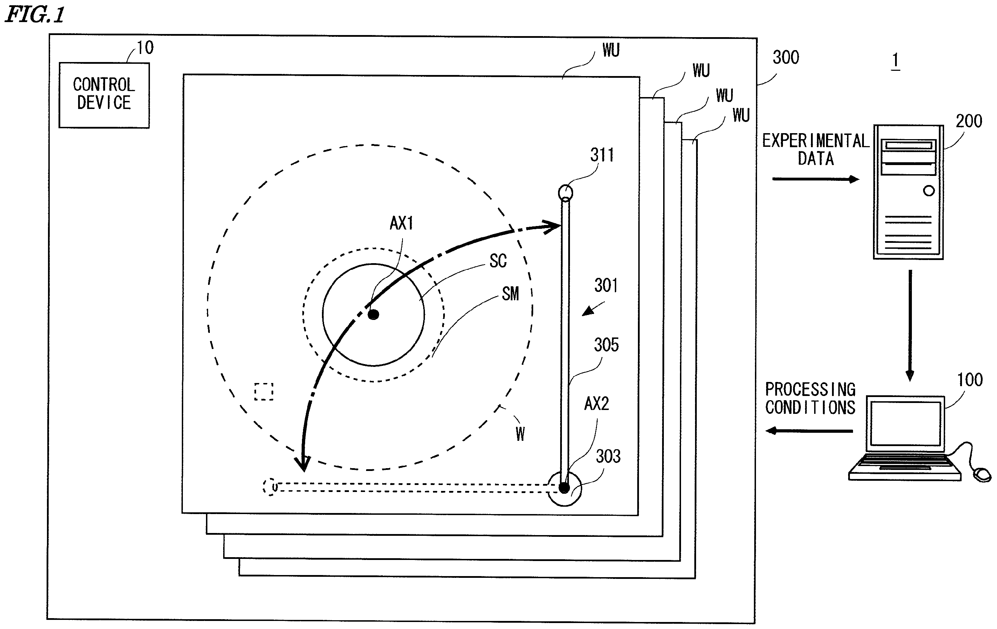

Fig. 1 is a diagram for explaining the configuration of the substrate processing system according to the one embodiment of the present invention. The substrate processing system 1 of Fig. 1 includes an information processing apparatus 100, a training device 200 and a substrate processing apparatus 300. The training device 200 is a server, for example, and the information processing apparatus 100 is a personal computer, for example.

The training device 200 and the information processing apparatus 100 are used to manage the substrate processing apparatus 300. The number of substrate processing apparatuses 300 managed by the training device 200 and the information processing apparatus 100 is not limited to one, and a plurality of substrate processing apparatuses 300 may be managed.

In the substrate processing system 1 according to the present embodiment, the information processing apparatus 100, the training device 200 and the substrate processing apparatus 300 are connected to one another by a wired communication line, a wireless communication line or a communication network. The information processing apparatus 100, the training device 200 and the substrate processing apparatus 300 are respectively connected to a network and can transmit and receive data to and from one another. As the network, a Local Area Network (LAN) or a Wide Area Network (WAN) is used, for example. Further, the network may be the Internet. Further, the information processing apparatus 100 and the substrate processing apparatus 300 may be connected to each other via a dedicated communication network. The connection state of the network may be wired or wireless.

The training device 200 is not necessarily required to be connected to the substrate processing apparatus 300 or the information processing apparatus 100 via a communication line or a communication network. In this case, the data generated in the substrate processing apparatus 300 may be transferred to the training device 200 via a recording medium. Further, the data generated in the training device 200 may be transferred to the information processing apparatus 100 via a recording medium.

In the substrate processing apparatus 300, a display device, a speech output device and an operation unit (not shown) are provided. The substrate processing apparatus 300 runs in accordance with predetermined processing conditions (processing recipe) of the substrate processing apparatus 300.

### 2. Outline of Substrate Processing Apparatus

The substrate processing apparatus 300 includes a control device 10 and a plurality of substrate processing units WU. The control device 10 controls the plurality of substrate processing units WU. Each of the plurality of substrate processing units WU process a substrate by supplying a processing liquid to the substrate W on which a film is formed. The processing liquid includes an etching liquid, and the substrate processing unit WU executes an etching process. The etching liquid is a chemical liquid. The etching liquid is a fluoronitric acid (a liquid mixture of hydrofluoric acid (HF) and nitric acid (HNO₃)), hydrofluoric acid, buffered hydrofluoric acid (BHF), ammonium fluoride, HFEG (a liquid mixture of hydrofluoric acid and ethylene glycol) or phosphoric acid (H₃PO₄), for example.

The substrate processing unit WU includes a spin chuck SC, a spin motor SM, a nozzle 311 and a nozzle moving mechanism 301. The spin chuck SC horizontally holds the substrate W. The spin motor SM has a first rotation shaft AX1. The first rotation shaft AX1 extends in an upward-and-downward direction. The spin chuck SC is attached to the upper end portion of the first rotation shaft AX1 of the spin motor SM. When the spin motor SM rotates, the spin chuck SC rotates about the first rotation shaft AX1. The spin motor SM is a stepping motor. The substrate W held by the spin chuck SC rotates about the first rotation shaft AX1. Therefore, the rotation speed of the substrate W is the same as the rotation speed of the stepping motor. In a case in which an encoder that generates a rotation speed signal indicating the rotation speed of the spin motor is provided, the rotation speed of the substrate W may be acquired from the rotation speed signal generated by the encoder. In this case, a motor other than the stepping motor can be used as the spin motor.

The nozzle 311 supplies the etching liquid to the substrate W. The etching liquid is supplied from an etching liquid supplier (not shown) to the nozzle 311, and the nozzle 311 discharges the etching liquid to the rotating substrate W.

The nozzle moving mechanism 301 moves the nozzle 311 in a substantially horizontal direction. Specifically, the nozzle moving mechanism 301 has a nozzle motor 303 having a second rotation shaft AX2 and a nozzle arm 305. The nozzle motor 303 is arranged such that the second rotation shaft AX2 extends in a substantially vertical direction. The nozzle arm 305 has a longitudinal shape extending linearly. One end of the nozzle arm 305 is attached to the upper end of the second rotation shaft AX2 such that the longitudinal direction of the nozzle arm 305 is different from the direction of the second rotation shaft AX2. The nozzle 311 is attached to the other end of the nozzle arm 305 such that the discharge port of the nozzle 311 is directed downwardly.

When the nozzle motor 303 works, the nozzle arm 305 rotates in a horizontal plane about the second rotation shaft AX2. Thus, the nozzle 311 attached to the other end of the nozzle arm 305 moves (turns) in the horizontal direction about the second rotation shaft AX2. The nozzle 311 discharges the etching liquid toward the substrate W while moving in the horizontal direction. The nozzle motor 303 is a stepping motor, for example.

The control device 10 includes a CPU (Central Processing Unit) and a memory, and controls the substrate processing apparatus 300 as a whole by execution by the CPU of a program stored in the memory. The control device 10 controls the spin motor SM and the nozzle motor 303.

The training device 200 receives experimental data from the substrate processing apparatus 300, causes a learning model to execute machine learning using the experimental data, and outputs the trained learning model to the information processing apparatus 100.

The information processing apparatus 100 determines processing conditions for processing a substrate to be processed by the substrate processing apparatus 300 using the trained learning model. The information processing apparatus 100 outputs the determined processing conditions to the substrate processing apparatus 300.

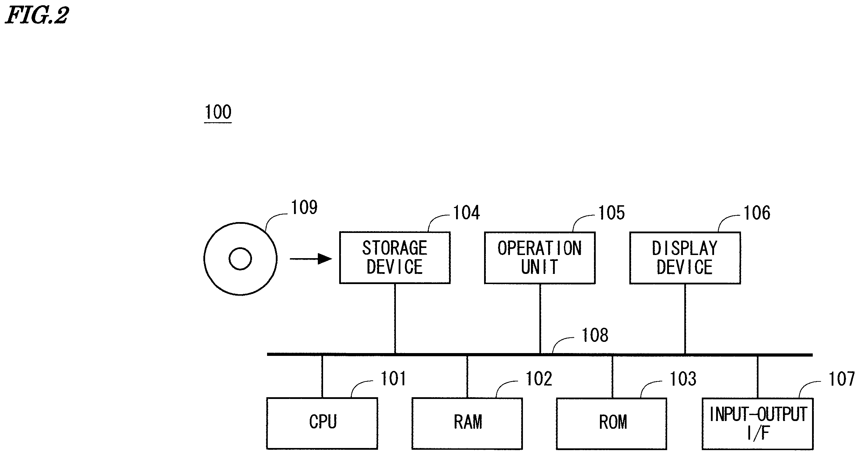

Fig. 2 is a diagram showing one example of the configuration of the information processing apparatus. With reference to Fig. 2, the information processing apparatus 100 includes a CPU 101, a RAM (Random Access Memory) 102, a ROM (Read Only Memory) 103, a storage device 104, an operation unit 105, a display device 106 and an input-output interface (I/F) 107. The CPU 101, the RAM 102, the ROM 103, the storage device 104, the operation unit 105, the display device 106 and the input-output I/F 107 are connected to a bus 108.

The RAM 102 is used as a work area for the CPU 101. A system program is stored in the ROM 103. The storage device 104 includes a storage medium such as a hard disc or a semiconductor memory and stores a program. The program may be stored in the ROM 103 or another external storage device.

A CD-ROM 109 is attachable to and detachable from the storage device 104. A recording medium storing a program to be executed by the CPU 101 is not limited to the CD-ROM 109. It may be an optical disc (MO (Magnetic Optical Disc)/MD (Mini Disc)/DVD (Digital Versatile Disc)), an IC card, an optical card, and a semiconductor memory such as a mask ROM or an EPROM (Erasable Programmable ROM). Further, the CPU 101 may download the program from a computer connected to the network and store the program in the storage device 104, or the computer connected to the network may write the program in the storage device 104, and the program stored in the storage device 104 may be loaded into the RAM 102 and executed in the CPU 101. The program referred to here includes not only a program directly executable by the CPU 101 but also a source program, a compressed program, an encrypted program and the like.

The operation unit 105 is an input device such as a keyboard, a mouse or a touch panel. A user can provide a predetermined instruction to the information processing apparatus 100 by operating the operation unit 105. The display device 106 is a display device such as a liquid crystal display device and displays a GUI (Graphical User Interface) or the like for receiving an instruction from the user. The input-output I/F 107 is connected to the network.

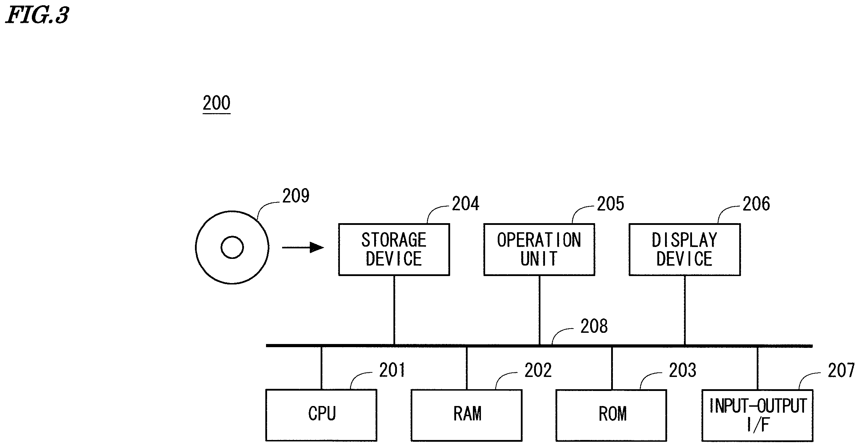

Fig. 3 is a diagram showing one example of the configuration of a training device. With reference to Fig. 3, the training device 200 includes a CPU 201, a RAM 202, a ROM 203, a storage device 204, an operation unit 205, a display device 206 and an input-output I/F 207. The CPU 201, the RAM 202, the ROM 203, the storage device 204, the operation unit 205, the display device 206 and the input-output I/F 207 are connected to a bus 208.

The RAM 202 is used as a work area for the CPU 201. A system program is stored in the ROM 203. The storage device 204 includes a storage medium such as a hard disc or a semiconductor memory and stores a program. The program may be stored in the ROM 203 or another external storage device. A CD-ROM 209 is attachable to and detachable from the storage device 204.

The operation unit 205 is an input device such as a keyboard, a mouse or a touch panel. The input-output I/F 207 is connected to the network.

### 3. Functional Configuration of Substrate Processing System

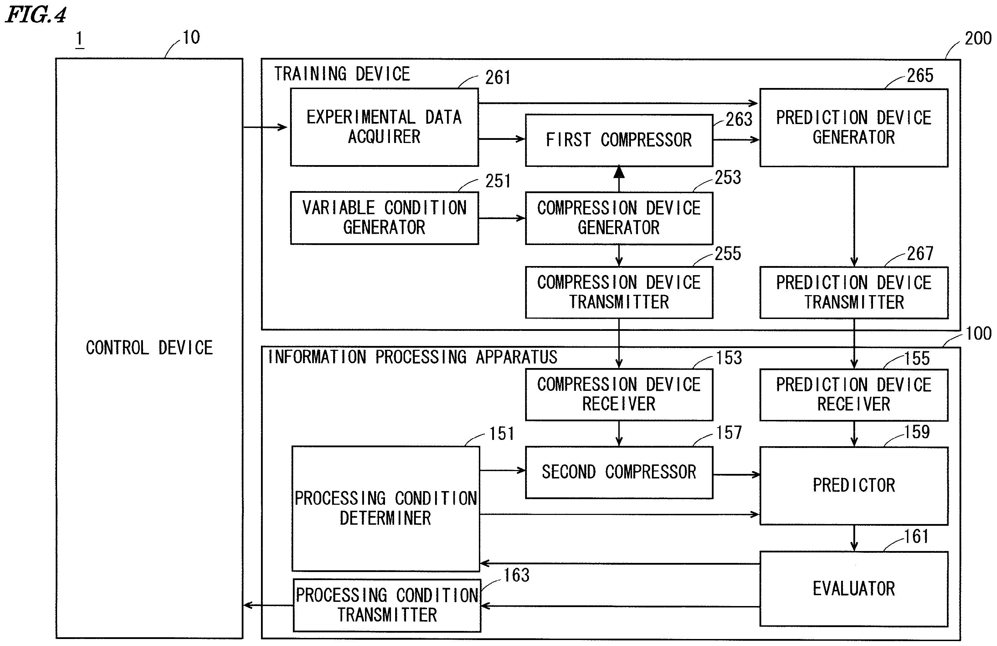

Fig. 4 is a diagram showing one example of the functional configuration of the substrate processing system in one embodiment of the present invention. With reference to Fig. 4, the control device 10 included in the substrate processing apparatus 300 controls the substrate processing unit WU to process the substrate W in accordance with processing conditions. The processing conditions are the conditions for processing the substrate W in a predetermined processing period of time. The processing period of time is the period of time defined for a substrate process. In the present embodiment, the processing period of time is the period of time during which the nozzle 311 discharges the etching liquid to the substrate W.

In the present embodiment, the processing conditions include a temperature of the etching liquid, a concentration of the etching liquid, a flow rate of the etching liquid, the number of rotations of the substrate W, and the relative positions of the nozzle 311 and the substrate W with respect to each other. The processing conditions include a variable condition that varies over time. In the present embodiment, the variable condition is the relative positions of the nozzle 311 and the substrate W with respect to each other. The relative positions are indicated by a rotation angle of the nozzle motor 303. The processing conditions include a fixed condition that does not vary over time. In the present embodiment, the fixed conditions include a temperature of the etching liquid, a concentration of the etching liquid, a flow rate of the etching liquid and the number of rotations of the substrate W.

The training device 200 causes a learning model to learn training data, and generates an inference model for inferring an etching profile based on the processing conditions. Hereinafter, an inference model generated by the training device 200 is referred to as a prediction device.

The training device 200 includes a variable condition generator 251, a compression device generator 253, a compression device transmitter 255, an experimental data acquirer 261, a first compressor 263, a prediction device generator 265 and a prediction device transmitter 267. The functions included in the training device 200 are implemented by execution by the CPU 201 included in the training device 200 of a training program stored in the RAM 202.

The variable condition generator 251 generates a variable condition. For example, the variable condition generator 251 generates a plurality of variable conditions by calculation. In the present embodiment, the substrate W rotates about the first rotation shaft AX1, and the nozzle 311 rotates about the second rotation shaft AX2. Therefore, a change in relative positions of the nozzle 311 and the substrate W with respect to each other is indicated by a change in position of the nozzle 311. The change in position of the nozzle 311 is defined by a rotation angle of the nozzle motor 303. Further, the angular rotation range of the nozzle motor 303 is limited to a predetermined range. Further, a processing period of time is a predetermined period. Therefore, it is possible to classify the changes in position of the nozzle 311 into a plurality of work patterns. A plurality of work patterns in which at least one of a movement velocity of the nozzle 311, a velocity-change position indicating a position at which the velocity is changed, a movement direction of the nozzle 311, and the number of times the nozzle 311 reverses the velocity, for example, is fixed are defined. The variable condition generator 251 defines a function for each of the plurality of work patterns, and generates a variable condition using the function.

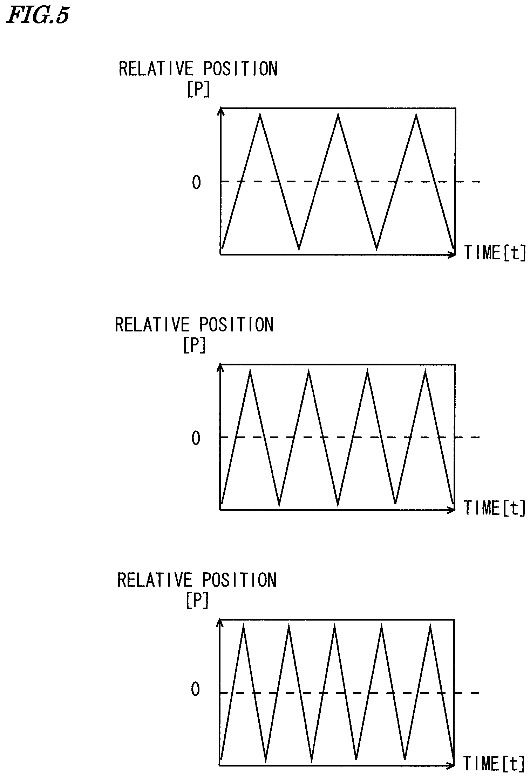

Fig. 5 is a diagram showing one example of the work pattern of the nozzle. With reference to Fig. 5, three variable conditions having the different numbers of times the nozzle 311 reverses the velocity and having the same other variables. In the upper portion, the graph for the variable condition in which the nozzle 311 reverses the velocity from a positive side to a negative side three times is shown. In the middle portion, the graph for the variable condition in which the nozzle 311 reverses the velocity from the positive side to the negative side four times is shown. In the lower portion, the graph for the variable condition in which the nozzle 311 reverses the velocity from the positive side to the negative side five times is shown.

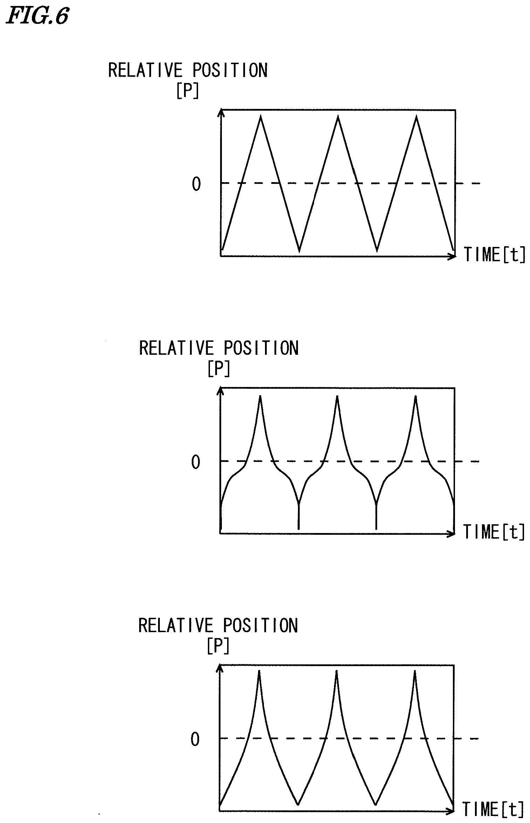

Fig. 6 is a diagram showing one example of the work pattern of the nozzle. With reference to Fig. 6, three variable conditions having the different accelerations at which the nozzle 311 accelerates and having the same other variables. In the upper portion, the graph for the variable condition in which the acceleration is a constant velocity is shown. In the middle portion, the graph for the variable condition in which the acceleration gradually decreases is shown. In the lower portion, the graph for the variable condition in which the acceleration gradually increases is shown.

Returning to Fig. 4, the compression device generator 253 generates a compression device by executing machine learning using a plurality of variable conditions generated by the variable condition generator 251. The compression device transmitter 255 transmits the compression device generated by the compression device generator 253 to the information processing apparatus 100.

The compression device generator 253 executes machine learning using a neural network. In the present embodiment, the compression device generator 253 is constituted by an autoencoder. The compression device generator 253 causes the autoencoder to execute machine learning using variable conditions generated by the variable condition generator 251. Specifically, the compression device generator 253 inputs the variable condition generated by the variable condition generator 251 to the autoencoder as generation input data, and determines parameters such that the output of the autoencoder is equal to the generation input data. The autoencoder includes an input layer, an intermediate layer and an output layer. The portion from the input layer to the intermediate layer is equivalent to a compression device, and the portion form the intermediate layer to the output layer is equivalent to a decoder. The compression device generator 253 generates a neural network in which the parameters set in the portion from the input layer to the intermediate layer of the trained autoencoder are incorporated as a compression device. The compression device is an inference program in which the parameters set in the portion from the input layer to the intermediate layer of the trained autoencoder are incorporated.

The compression device generator 253 may normalize a variable condition and cause the autoencoder to execute machine learning using the normalized variable condition. A variable condition indicates the relative position of the nozzle 311 with respect to the substrate W, and the relative position is in the range from - 150 mm to 150 mm, by way of example. When the variable condition is normalized, values are scaled in the range of 0 to 1. When the variable condition is normalized, the range for a parameter is standardized, and it facilitates machine learning executed by the autoencoder.

The compression device generator 253 classifies a plurality of variable conditions prepared in advance for machine learning into a first variable condition used for machine learning and a second variable condition used for evaluation of a compression device, causes the autoencoder to execute machine learning on the first variable condition, and evaluates the performance of the autoencoder according to the second variable condition.

The experimental data acquirer 261 acquires experimental data from the substrate processing apparatus 300. The experimental data includes processing conditions used when the substrate processing apparatus 300 actually processes the substrate W, and film-thickness characteristics of a film formed on the substrate W before and after the process. The film-thickness characteristic is indicated by the film thickness of a film formed on the substrate W at each of a plurality of different positions in a radial direction of the substrate W.

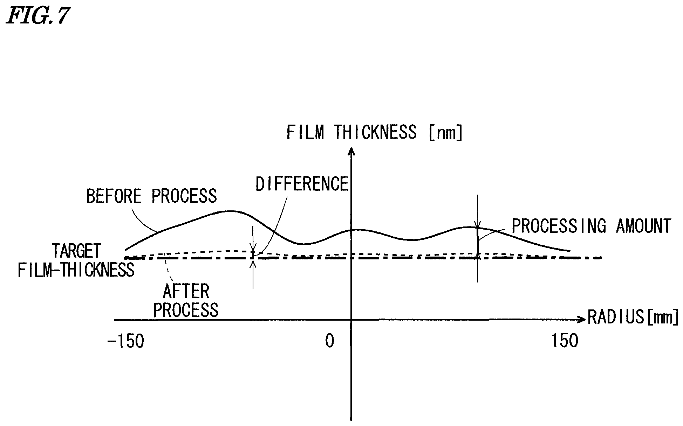

Fig. 7 is a diagram showing one example of the film-thickness characteristic. With reference to Fig. 7, the abscissa indicates a position in the radial direction of the substrate, and the ordinates indicate a film thickness. The origin of the abscissa indicates the center of the substrate. The film thickness of a film formed on the substrate W before the substrate W is processed by the substrate processing apparatus 300 is indicated by the solid line. The substrate processing apparatus 300 executes a process of applying an etching liquid in accordance with processing conditions, thereby adjusting the film thickness of the film formed on the substrate W. The film thickness of the film formed on the substrate W after the substrate W is processed by the substrate processing apparatus 300 is indicated by the dotted line.

The difference between the film thickness of the film formed on the substrate W before the substrate W is processed by the substrate processing apparatus 300 and the film thickness of the film formed on the substrate W after the substrate W is processed by the substrate processing apparatus 300 is a processing amount (etching amount). The processing amount indicates the film thickness by which the film is reduced in the process of applying the etching liquid by the substrate processing apparatus 300. The distribution in the radial direction of the processing amount is referred to as an etching profile. The etching profile includes the processing amount at each of the plurality of positions in the radial direction of the substrate W.

Further, it is desirable that the film thickness of a film formed by the substrate processing apparatus 300 is uniform over the entire surface of the substrate W. Therefore, a target film-thickness is defined for the process executed by the substrate processing apparatus 300. The target film-thickness is indicated by the one-dot and dash line. A deviation characteristic is the difference between the film thickness of a film formed on the substrate W after the substrate W is processed by the substrate processing apparatus 300 and the target film-thickness. The deviation characteristic includes the difference generated at each of the plurality of positions in the radial direction of the substrate W.

Returning to Fig. 4, the first compressor 263 converts a variable condition included in processing conditions of experimental data received from the experimental data acquirer 261 into a low-dimensional data set using a compression device generated by the compression device generator 253. Here, the compression device generated by the compression device generator 253 is a neural network. The first compressor 263 inputs the variable condition to the neural network which is the compression device, and outputs a conversion result provided by the compression device to the prediction device generator 265.

The prediction device generator 265 receives the conversion result obtained when the variable condition is converted from the first compressor 263 and receives the experimental data from the experimental data acquirer 261. The prediction device generator 265 generates a prediction device by causing the neural network to execute supervised learning.

Specifically, training data includes input data and ground truth data. The input data includes the conversion result obtained when the variable condition is converted by the first compressor 263 and fixed conditions other than the variable condition of the processing conditions included in the experimental data. The ground truth data includes an etching profile. The etching profile is the difference between the film-thickness characteristic of a film that is obtained before the process and included in the experimental data, and the film-thickness characteristic of the film that is obtained after the process and included in the experimental data. The prediction device generator 265 inputs the input data to the neural network and determines parameters of the neural network such that the output of the neural network is equal to the ground truth data. The prediction device generator 265 generates, as a prediction device, a neural network in which the parameters set in the trained neural network are incorporated. The prediction device is an inference program in which the parameters set in the trained neural network are incorporated. The prediction device generator 265 transmits the prediction device to the information processing apparatus 100.

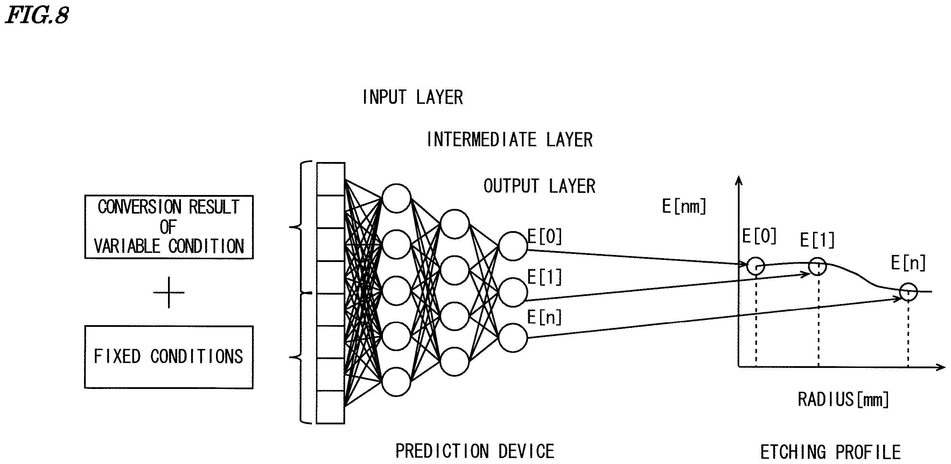

Fig. 8 is a diagram for explaining a prediction device. With reference to Fig. 8, the prediction device includes an input layer, an intermediate layer and an output layer, and each layer includes a plurality of nodes indicated by the circles. While one intermediate layer is shown in the diagram, the number of intermediate layers may be larger than one. Also, although five nodes are shown in the input layer, four nodes are shown in the intermediate layer, and three nodes are shown in the output layer, the numbers of nodes are not limited to these. The output of nodes in an upper layer is connected to the input of nodes in a lower layer. A parameter includes a coefficient for weighting the output of nodes in the upper layer. Further, the number of the intermediate layers is equal to or larger than 1 and not limited.

When a conversion result obtained when a variable condition is converted into a low-dimensional data set and fixed conditions are input to a prediction device, an etching profile is output. The etching profile is represented by the difference E[n] between the film thickness obtained before a process and the film thickness obtained after the process at each of a plurality of positions P[n] (n is an integer equal to or larger than 1) in the radial direction of the substrate W. Although the number of output nodes of the prediction device is three in the diagram, the number of output nodes is actually n.

Returning to Fig. 4, the information processing apparatus 100 includes a processing condition determiner 151, a compression device receiver 153, a prediction device receiver 155, a second compressor 157, a predictor 159, an evaluator 161 and a processing condition transmitter 163. The functions included in the information processing apparatus 100 are implemented by execution, by the CPU 101 included in the information processing apparatus 100, of a processing condition determination program stored in the RAM 102.

The compression device receiver 153 receives a compression device transmitted from the training device 200 and outputs the received compression device to the second compressor 157. The prediction device receiver 155 receives a prediction device transmitted from the training device 200 and outputs the received prediction device to the predictor 159.

The processing condition determiner 151 determines processing conditions for the substrate W to be processed by the substrate processing apparatus 300. The processing condition determiner 151 outputs a variable condition included in the processing condition to the second compressor 157, and outputs fixed conditions included in the processing condition to the predictor 159. Using design of experiments, pairwise testing or Bayesian inference, the processing condition determiner 151 selects one of a plurality of variable conditions that are prepared in advance and determines processing conditions including the selected variable condition and the selected fixed conditions as processing conditions for prediction to be made by the predictor 159. As the plurality of variable conditions prepared in advance, a plurality of variable conditions generated for generation of a compression device by the training device 200 are preferably used.

The second compressor 157 compresses a variable condition received from the processing condition determiner 151 using a compression device. Specifically, the second compressor 157 inputs the variable condition to the compression device, and outputs the output of the compression device to the predictor 159 as a conversion result.

By using the prediction device, the predictor 159 predicts an etching profile based on the conversion result of the variable condition provided by the compression device and fixed conditions. Specifically, the predictor 159 inputs the conversion result received from the second compressor 157 and the fixed conditions received from the processing condition determiner 151 to the prediction device, and outputs the etching profile output by the prediction device to the evaluator 161.

The evaluator 161 evaluates the etching profile received from the predictor 159 and outputs the evaluation result to the processing condition determiner 151. In detail, the evaluator 161 acquires the film-thickness characteristic obtained before the substrate W to be processed by the substrate processing apparatus 300 is processed. The evaluator 161 calculates the film-thickness characteristic predicted to be obtained after the etching process based on the etching profile received from the predictor 159 and the film-thickness characteristic before the substrate W is processed, and compares the calculated film-thickness characteristic with target film-thickness characteristic. When the comparison result satisfies an evaluation criterion, the processing conditions determined by the processing condition determiner 151 are output to the processing condition transmitter 163. For example, the evaluator 161 calculates a deviation characteristic and determines whether the deviation characteristic satisfies the evaluation criterion. The deviation characteristic is the difference between the film-thickness characteristic of the substrate W obtained after the etching process and the target film-thickness characteristic. The evaluation criterion can be arbitrarily defined. For example, the evaluation criterion may be that the maximum value of difference in regard to the deviation characteristic is equal to or smaller than a threshold value, or that the average of differences is equal to or smaller than the threshold value.

The processing condition transmitter 163 transmits the processing conditions determined by the processing condition determiner 151 to the substrate processing apparatus 300. The substrate processing apparatus 300 processes the substrate W in accordance with the processing conditions.

In a case in which the evaluation result does not satisfy the evaluation criterion, the evaluator 161 outputs the evaluation result to the processing condition determiner 151 . The evaluation result includes the difference between a film-thickness characteristic predicted to be obtained after the etching process and a target film-thickness characteristic.

In response to receiving the evaluation result from the evaluator 161, the processing condition determiner 151 determines new processing conditions for prediction to be made by the predictor 159. Using design of experiments, pairwise testing or Bayesian inference, the processing condition determiner 151 selects one of a plurality of variable conditions that are prepared in advance and determines processing conditions including a selected variable condition and selected fixed conditions as new processing conditions for prediction to be made by the predictor 159.

The processing condition determiner 151 may search for processing conditions using Bayesian inference. In a case in which a plurality of evaluation results are output by the evaluator, a plurality of sets each of which includes processing conditions and an evaluation result are obtained. Based on the likelihood of the etching profile for each of the plurality of sets, the processing conditions that cause the film thickness to be uniform or the processing conditions that cause the difference between a film-thickness characteristic predicted to be obtained after an etching process and a target film-thickness characteristic to be minimized are searched.

Specifically, the processing condition determiner 151 searches for the processing conditions that cause an objective function to be minimized. The objective function is a function representing the uniformity of film thickness of the film or a function representing the coincidence between the film-thickness characteristic of the film and the target film-thickness characteristic. For example, the objective function is a function that represents the difference between the film-thickness characteristic predicted to be obtained after the etching process and the target film-thickness characteristic using a parameter. The parameter here is a conversion result obtained by conversion of a corresponding variable condition by the second compressor 157. The corresponding variable condition is a variable condition before the conversion result used by the prediction device to predict the etching profile is converted. The processing condition determiner 151 selects a variable condition corresponding to a conversion result which is a parameter determined by search among a plurality of variable conditions, and determines new processing conditions including the selected variable condition and fixed conditions.

Instead of selecting one of variable conditions prepared in advance, the processing condition determiner 151 may select a variable condition obtained when a parameter obtained by search is decoded by the decoder. The decoder is part of an autoencoder including the compression device generator 253 of the training device 200.

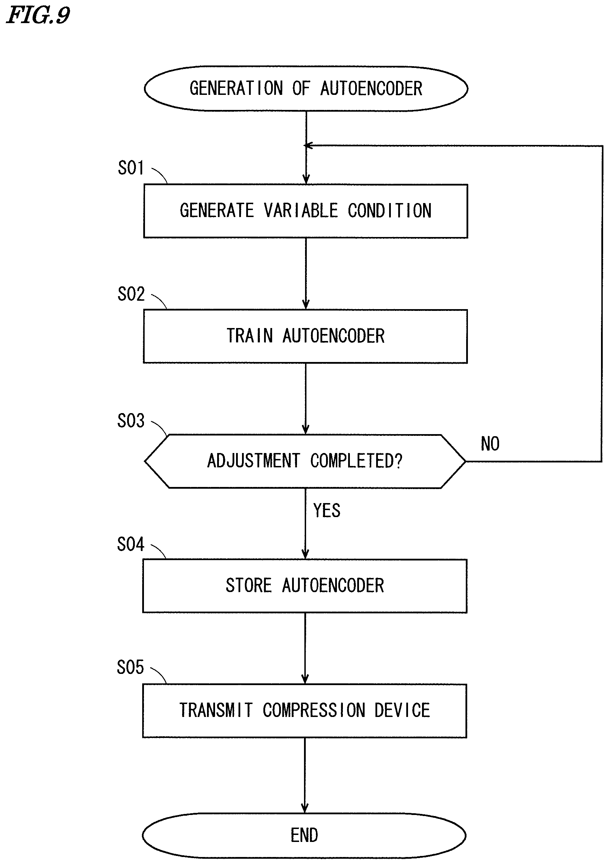

Fig. 9 is a flowchart showing one example of a flow of an autoencoder generation process. The autoencoder generation process is a process executed by the CPU 201 included in the training device 200 when the CPU 201 executes an autoencoder generation program stored in the RAM 202. The autoencoder generation program is part of the training program.

With reference to Fig. 9, in the CPU 201 included in the training device 200, a variable condition is generated, and the process proceeds to the step S02. A plurality of work patterns representing a change in position of the nozzle 311 are predetermined, and one of the plurality of work patterns is selected. Then, the function corresponding to the selected work pattern is selected, and a variable condition is generated when a parameter is sequentially varied.

In the step S02, the CPU 201 causes an autoencoder to learn, and the process proceeds to the step S03. A variable condition generated in the step S01 is set for input and output, a parameter of a neural network is adjusted. The variable condition is sampled at predetermined sampling intervals. In the present embodiment, the processing period of time is 20 seconds, and the sampling interval is 0.01 seconds. Therefore, the variable condition is the data in which 2000 position data sets indicating positions are arranged in a chronological order.

In the step S03, whether adjustment has completed is determined. A variable condition used for evaluation of a compression device is prepared in advance, and the performance of the autoencoder is evaluated according to the variable condition for evaluation. In a case in which the evaluation result satisfies a predetermined evaluation criterion, it is determined that adjustment is completed. If the evaluation result does not satisfy the evaluation criterion (NO in the step S03), the process returns to the step S01. If the evaluation result satisfies the evaluation criterion (YES in the step S03), the process proceeds to the step S04.

In a case in which the process returns to the step S01, a new work pattern is generated in the step S01. In the loop of the step S01 to the step S03, the CPU 201 causes the autoencoder to execute machine learning using a plurality of variable conditions. Thus, the parameters of the autoencoder are adjusted to appropriate values.

In the step S04, the autoencoder is stored in the storage device 104, and the process proceeds to the step S05. The autoencoder is a neural network in which the parameter adjusted by machine learning is set.

In the step S05, a compression device is transmitted, and the process ends. The CPU 201 controls the input-output I/F 107 and transmits, as a compression device, the portion from the input layer to the intermediate layer of the autoencoder to the information processing apparatus 100.

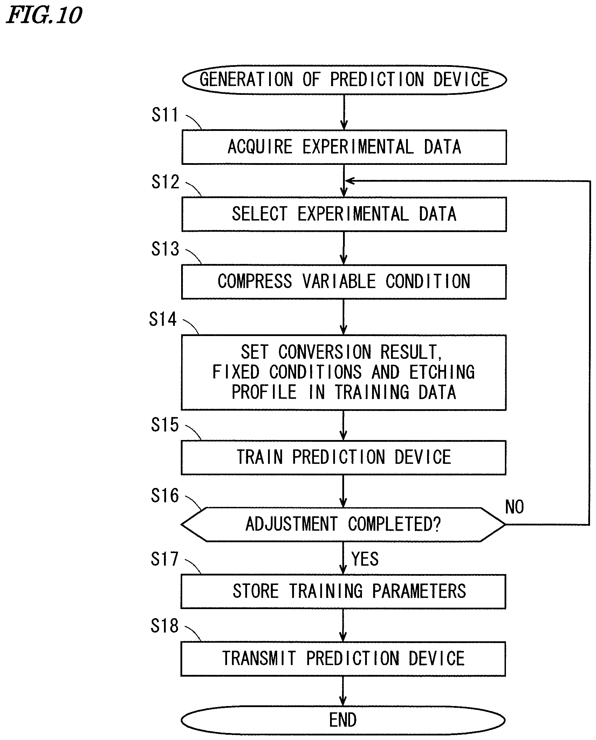

Fig. 10 is a flowchart showing one example of a flow of a prediction device generation process. The prediction device generation process is a process executed by the CPU 201 included in the training device 200 when the CPU 201 executes a prediction device generation program stored in the RAM 202. The prediction device generation program is part of the training program.

With reference to Fig. 10, the CPU 201 included in the training device 200 acquires experimental data. The CPU 201 controls the input-output I/F 107 to acquire the experimental data from the substrate processing apparatus 300 (step S11). The experimental data may be acquired when the experimental data recorded in a recording medium such as the CD-ROM 209 is read by the storage device 104. A plurality of experimental data sets are acquired here. The experimental data sets include processing conditions and the film-thickness characteristics of a film formed on the substrate W obtained before and after a process. The film-thickness characteristics are represented by the film thicknesses of the film formed on the substrate W at each of a plurality of different positions in the radial direction of the substrate W.

In the next step S12, an experimental data set to be processed is selected, and the process proceeds to the step S13. A variable condition included in the experimental data set is compressed in the step S13, and the process proceeds to the step S14. The variable condition is input to a compression device generated by the training device 200, and the output of the compression device is acquired as a conversion result.

In the step S14, the conversion result, fixed conditions included in the experimental data sets, and an etching profile are set in training data. The etching profile is the difference between the film-thickness characteristic of a film that is obtained before a process and included in the experimental data sets, and the film-thickness characteristic of the film that is obtained after the process and included in the experimental data sets. The training data includes input data and ground truth data. The conversion result provided by the compression device and calculated in the step S13 and the fixed conditions included in the experimental data sets are set in the input data. The etching profile is set as the ground truth data.

In the next step S15, the CPU 201 causes the prediction device to execute machine learning, and the process proceeds to the step S16. The input data is input to the prediction device which is a neural network, and parameters are determined such that the output of the prediction device is equal to the ground truth data. Thus, parameters of the prediction device are adjusted. The prediction device is a neural network having the parameters determined by machine learning using the training data.

In the step S16, whether adjustment has completed is determined. Training data used for evaluation of the prediction device is prepared in advance, and the performance of the prediction device is evaluated using the training data for evaluation. In a case in which the evaluation result satisfies a predetermined evaluation criterion, it is determined that adjustment is completed. If the evaluation result does not satisfy the evaluation criterion (NO in the step S16), the process returns to the step S12. If the evaluation result satisfies the evaluation criterion (YES in the step S16), the process proceeds to the step S17.

In a case in which the process returns to the step S12, an experimental data set that has not been selected as being subjected to a process is selected from the experimental data sets acquired in the step S11. In the loop of the step S12 to the step S16, the CPU 201 causes the prediction device to execute machine learning using a plurality of training data sets. Thus, parameters of the prediction device which is a neural network are adjusted to appropriate values. In the step S18, the prediction device is transmitted, and the process ends. The CPU 201 controls the input-output I/F 107 and transmits the prediction device to the information processing apparatus 100.

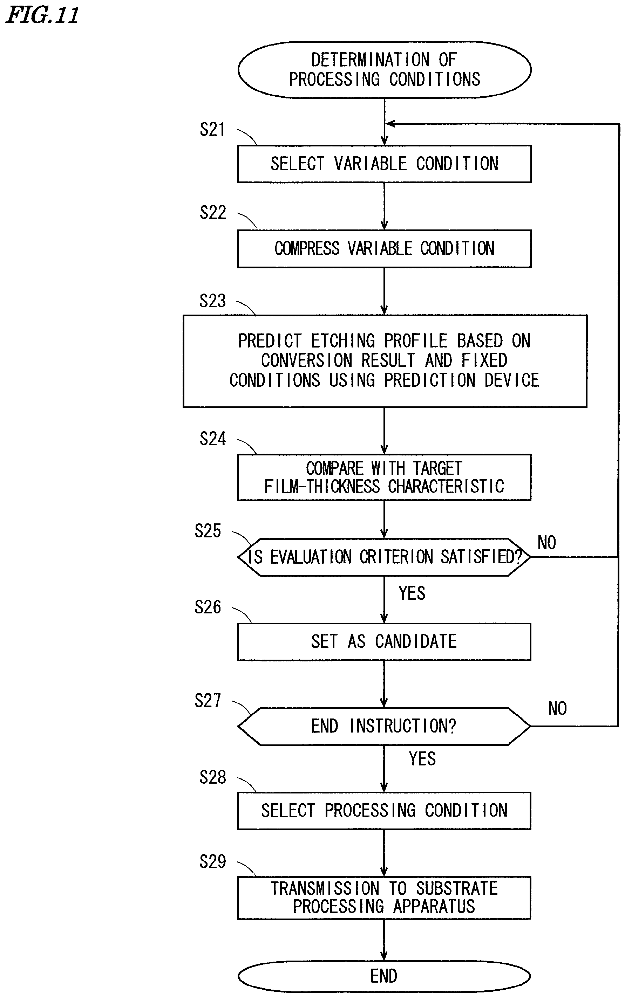

Fig. 11 is a flowchart showing one example of a flow of a processing condition determination process. The processing condition determination process is a process executed by the CPU 101 when the CPU 101 included in the information processing apparatus 100 executes the processing condition determination program stored in the RAM 102.

With reference to Fig. 11, the CPU 101 included in the information processing apparatus 100 selects one of a plurality of variable conditions that are prepared in advance (step S21), and the process proceeds to the step S22. The plurality of variable conditions are a plurality of variable conditions generated for generation of a compression device by the training device 200. Using design of experiments method, pairwise testing, Bayesian inference or the like, one of the plurality of variable conditions prepared in advance is selected.

In the step S22, the variable condition is compressed, and the process proceeds to the step S23. The variable condition is compressed using the compression device generated by the training device 200. Here, the variable condition is input to the compression device, and its output is acquired as a conversion result.

In the step S23, an etching profile is predicted based on the conversion result and fixed conditions using the prediction device, and the process proceeds to step S24. The conversion result and the fixed conditions are input to the prediction device, and the etching profile output by the prediction device is acquired. In the step S24, a film-thickness characteristic obtained after a process is compared with a target film-thickness characteristic. Based on a film-thickness characteristic obtained before the process of the substrate W to be processed by the substrate processing apparatus 300 and the etching profile predicted in the step S23, a film-thickness characteristic obtained after the substrate W is processed is calculated. Then, the film-thickness characteristic obtained after the process is compared with the target film-thickness characteristic. Here, the difference between the film-thickness characteristic obtained after the substrate W is processed and the target film-thickness characteristic is calculated.

In the step S25, whether the comparison result satisfies an evaluation criterion is determined. If the comparison result satisfies the evaluation criterion (YES in the step S25), the process proceeds to the step S26. If not, the process returns to the step S21. For example, in a case in which the maximum value for the difference is equal to or smaller than a threshold value, it is determined that the evaluation criterion is satisfied. Further, in a case in which the average value for the difference is equal to or smaller than a threshold value, it is determined that the evaluation criterion is satisfied.

In the step S26, processing conditions including a variable condition selected immediately before in the step S21 is set as a candidate of a processing condition for driving the substrate processing apparatus 300, and the process proceeds to the step S27. In the step S27, whether an instruction for ending a search has been accepted is determined. If an end instruction provided by the user who operates the information processing apparatus 100 is accepted, the process proceeds to the step S28. If not, the process returns to the step S21. Instead of the end instruction input by the user, whether a predetermined number of processing conditions have been set as candidates may be determined.

In the step S28, one of the one or more processing conditions set as the candidates is selected, and the process proceeds to the step S29. One of the one or more processing conditions set as the candidates may be selected by the user who operates the information processing apparatus 100. This widens the range of selection for the user. Further, a variable condition according to which the nozzle work can be performed most simply may be automatically selected from among variable conditions included in a plurality of processing conditions. The variable condition according to which the nozzle work is performed most simply can be a variable condition according to which the nozzle work is performed with the smallest number of positions at which the velocity is changed, for example. Thus, a plurality of variable conditions can be presented in regard to a processing result for the complicated nozzle work for processing the substrate W. When a variable condition according to which the nozzle is easily controlled is selected from among a plurality of variable conditions, the control of the substrate processing apparatus 300 is facilitated.

In the step S29, the processing conditions including the variable condition determined in the step S28 are transmitted to the substrate processing apparatus 300, and the process ends. The CPU 101 controls the input-output I/F 107 and transmits the processing conditions to the substrate processing apparatus 300. In a case in which receiving the processing conditions from the information processing apparatus 100, the substrate processing apparatus 300 processes the substrate W in accordance with the processing conditions.

### 4. Specific Examples

In the present embodiment, a variable condition is the time-series data that is sampled at sampling intervals of 0.01 seconds with a processing period of time for the nozzle work being 20 seconds. The variable condition includes 2000 values. Therefore, the variable condition can express a complicated nozzle work. In particular, the nozzle work having the relatively large number of positions at which the moving velocity of the nozzle is changed can be accurately represented using a variable condition.

The compression device generator 253 in the present embodiment causes an autoencoder to execute machine learning so as to convert a variable condition into a two-dimensional data set. Therefore, a compression device generated by the compression device generator 253 converts the variable condition including 2000 values into a two-dimensional data set. The inventor of the present invention has discovered through an experiment that, even in a case in which the variable condition including 2000 values and indicating complicated nozzle work is converted into the two-dimensional data set, a desired result is obtained as an etching profile predicted by the prediction device.

Therefore, because the number of data sets to be input to the prediction device can be reduced, the configuration of the prediction device can be simplified, and a neural network can be easily trained. Further, parameters of the neural network can be adjusted to appropriate values, and the accuracy of the prediction device can be improved.

Further, because the variable condition the number of dimensions of which is 2000 is converted into the two-dimensional data set, a plurality of variable conditions that cause an equal conversion result among a plurality of variable conditions may be present. In this case, the etching profiles predicted by the prediction device based on the plurality of variable conditions that cause the same conversion result are the same. In the present embodiment, when searching for processing conditions, the processing condition determiner 151 searches for processing conditions respectively corresponding to different etching profiles. Therefore, the processing conditions corresponding to the plurality of different etching profiles are selected. Therefore, the processing condition determiner 151 can efficiently search for processing conditions according to which the target etching profile is predicted to be obtained from among a plurality of processing conditions.

While being set to 0.01 seconds by way of example, the sampling interval is not limited to this. The sampling interval may be longer or shorter than this. For example, the sampling interval may be 0.1 seconds or 0.005 seconds. In short, the number of dimensions of a conversion result obtained when a variable condition is converted by a compression device is simply required to be two regardless of the number of dimensions of the variable condition.

### 5. Other Embodiments

(1) In the above-mentioned embodiment, the training device 200 generates a prediction device based on training data. The training device 200 may additionally train a prediction device. After a prediction device is generated, the training device 200 acquires the film-thickness characteristics of a film obtained before and after the substrate W is processed, and processing conditions. Then, the training device 200 generates training data based on the film-thickness characteristics of the film obtained before and after the process, and the processing conditions, and causes the prediction device to execute machine learning, thereby additionally training the prediction device. The additional training does not change the configuration of a neural network constituting the prediction device, but adjusts parameters.

Because the prediction device executes machine learning using the information obtained as a result of the actual process executed on the substrate W by the substrate processing apparatus 300, the accuracy of the prediction device can be improved. Further, the number of training data sets used for generating the prediction device can be reduced as much as possible.

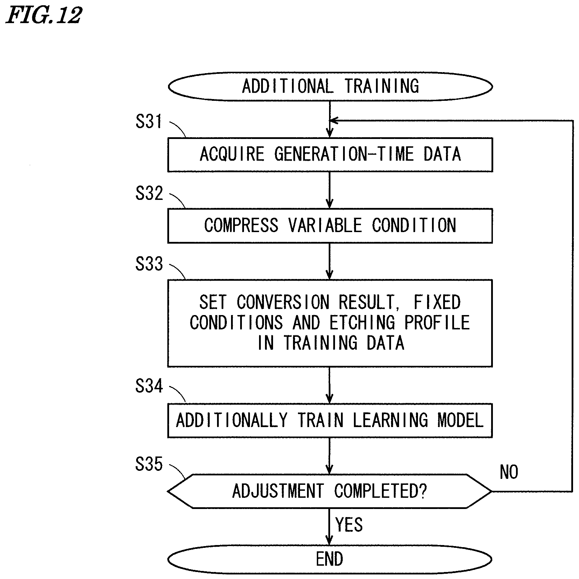

Fig. 12 is a flowchart showing one example of a flow of an additional training process. The additional training process is a process executed by the CPU 201 included in the training device 200 when the CPU 201 executes an additional training program stored in the RAM 202. The additional training program is part of the training program.

With reference to Fig. 12, the CPU 201 included in the training device 200 acquires generation-time data (step S031), and the process proceeds to the step S32. The generation-time data includes processing conditions for a process executed on the substrate W by the substrate processing apparatus 300 and film-thickness characteristics of a film obtained before and after the process. The CPU 201 controls the input-output I/F 107 and acquires the generation-time data from the substrate processing apparatus 300. The generation-time data may be acquired when experimental data recorded in a recording medium such as the CD-ROM 209 is read by the storage device 104.

In the step S32, a variable condition is compressed, and the process proceeds to the step S33. The variable condition is input to a compression device generated by the training device 200, and the output of the compression device is acquired as a conversion result. In the step S33, the conversion result, fixed conditions included in the processing conditions of the generation-time data and an etching profile are set. The etching profile is the difference between the film-thickness characteristic of a film that is obtained before a process and included in the generation-time data and the film-thickness characteristic of the film that is obtained after the process and included in the generation-time data. The conversion result provided by the compression device and the fixed conditions included in the processing conditions are set in input data. The etching profile is set as ground truth data.

In the next step S34, the CPU 201 additionally trains the prediction device, and the process proceeds to the step S35. The input data is input to the prediction device which is a neural network, and parameters are determined such that the output of the prediction device is equal to the ground truth data. Thus, parameters of the prediction device are further adjusted.

In the step S35, whether adjustment has completed is determined. The performance of the prediction device is evaluated using training data for evaluation. In a case in which the evaluation result satisfies a predetermined additional training evaluation criterion, it is determined that adjustment is completed. The additional training evaluation criterion is a criterion higher than an evaluation criterion used in a case in which a prediction device is generated. If the evaluation result does not satisfy the additional training evaluation criterion (NO in the step S35), the process returns to the step S31. If the evaluation result satisfies the additional training evaluation criterion (YES in the step S35), the process ends.

(2) The training device 200 may generate a distillation model obtained when a new learning model executes machine training, by using distillation data that includes processing conditions determined by the information processing apparatus 100 and an etching profile predicted by a prediction device based on the processing conditions. This facilitates preparation of data for training a new learning model.

(3) While the training device 200 generates a compression device by causing an autoencoder to execute machine learning, the present invention is not limited to this. The compression device may reduce the dimension of the temporal change of the relative positions of the nozzle 311 and the substrate W with respect to each other by another method.

(4) In the present embodiment, in the training data used for generation of a prediction device, input data includes a conversion result obtained when a variable condition is converted and fixed conditions The present invention is not limited to this. The input data may include only a conversion result obtained when a variable condition is converted, and does not have to include the fixed conditions

(5) While the relative positions of the nozzle 311 and the substrate W with respect to each other are shown as one example of a variable condition in the present embodiment, the present invention is not limited to this. In a case in which at least one of a temperature of an etching liquid, a concentration of the etching liquid, a flow rate of the etching liquid, and the number of rotations of the substrate W varies over time, they may be a variable condition. Further, the number of types of variable conditions is not limited to one, and may be two or more.

(6) While the information processing apparatus 100 and the training device 200 are separated from the substrate processing apparatus 300 by way of example, the present invention is not limited to this. The information processing apparatus 100 may be incorporated in the substrate processing apparatus 300. Further, the information processing apparatus 100 and the training device 200 may be incorporated in the substrate processing apparatus 300. While being separate apparatuses, the information processing apparatus 100 and the training device 200 may be configured as an integrated apparatus.

### 6. Effects of Embodiments

The training device 200 in the present embodiment acquires a processing amount indicating the difference between the film thickness of a film formed on the substrate W obtained before a process and the film thickness of the film formed on the substrate W obtained after the process, after the substrate processing apparatus 300 is driven according to processing conditions including a variable condition, causes a neural network to execute machine learning using training data that includes a conversion result obtained when the variable condition is converted by a compression device and includes an etching profile corresponding to the processing conditions as ground truth data, and generates a prediction device that is a learning model for predicting the etching profile. Because the training data includes, as input data, the conversion result obtained when the variable condition that varies over time is converted such that the number of dimensions is reduced, it is possible to reduce the number of dimensions of training data. Therefore, it is possible to generate the training device suitable for machine learning using a condition that varies over time for the process for the substrate W.

Further, the training device 200 generates a plurality of variable conditions in a range in which the substrate processing apparatus 300 can be driven, and causes an autoencoder to execute machine learning using the plurality of generated variable conditions to generate a compression device. Therefore, the compression device is generated when the autoencoder learns the variable conditions, it facilitates generation of the compression device.

Further, the processing conditions include a variable condition and fixed conditions that do not vary over time. Therefore, it is possible to manage a process with different fixed conditions, and it is not necessary to generate a plurality of learning models with different fixed conditions.

After generating a prediction device, the training device 200 acquires a processing amount indicating the difference between the film thicknesses of a film formed on the substrate W obtained before and after a process is executed by the substrate processing apparatus 300 on the substrate W according to processing conditions, and causes a learning model to learn additional training data that includes a conversion result obtained when a temporary variable condition is converted by a compression device and the acquired processing amount. Therefore, because the learning model is additionally trained, the performance of the learning model can be improved.

Further, in a case in which a conversion result obtained when a temporary variable condition is converted by a compression device is provided to a learning model, and a processing amount predicted by the learning model satisfies an allowable condition, the training device 200 generates a new learning model using distillation data including the conversion result and the processing amount predicted by the learning model. This facilitates preparation of data for training a new learning model.

Further, the substrate processing apparatus 300 includes the nozzle 311 that supplies a processing liquid to the substrate W and the nozzle moving mechanism 301 that changes the relative positions of the nozzle and the substrate W with respect to each other, and a variable condition is the relative positions of the nozzle 311 changed by the nozzle moving mechanism 301 and the substrate W with respect to each other. The relative positions of the nozzle 311 and the substrate W with respect to each other are changed, and a processing liquid is supplied to the substrate W from the nozzle 311, so that a learning model for predicting a processing amount of a film is generated. Therefore, it is possible to generate the learning model that predicts the processing amount in the etching process.

Further, in a case in which a conversion result obtained when a temporary variable condition is converted by a compression device generated by the training device 200 is provided to a learning model generated by the training device 200, and an etching profile predicted by the learning model satisfies an allowable condition, the information processing apparatus 100 determines processing conditions including the temporary variable condition as processing conditions for driving the substrate processing apparatus 300. Therefore, because the etching profile is predicted based on the processing conditions, it is not necessary to obtain the influence of the complicated nozzle work on the processing result of an etching process by an experiment or the like. Further, because a plurality of temporary variable conditions are determined for the processing amount satisfying the allowable condition, it is possible to determine a plurality of variable conditions respectively corresponding to a plurality of etching profiles satisfying the allowable condition. Therefore, the plurality of variable conditions can be presented for the processing result of the complicated process for the substrate. When a variable condition according to which the nozzle work is easily controlled is selected from among the plurality of variable conditions, it facilitates the control of the substrate processing apparatus 300.

Further, because determining a plurality of processing conditions for a processing amount satisfying an allowable condition, the information processing apparatus 100 can determine the plurality of processing conditions respectively corresponding to a plurality of etching profiles satisfying the allowable condition. Further, fixed conditions include the temperature of an etching liquid. Therefore, the temperatures of a plurality of etching liquids can be presented in regard to a processing result of the complicated process of processing a substrate. Further, the temperature of the etching liquid which is easily applied to the etching process can be selected from among the temperatures of the plurality of etching liquids. Because the temperature of the etching liquid that can be easily applied can be selected, the temperature of the etching liquid used for the etching process can be easily adjusted.

### 7. Correspondences Between Constituent Elements in Claims and Parts in Preferred Embodiments

The substrate W is an example of a substrate, the etching liquid is an example of a processing liquid, the substrate processing apparatus 300 is an example of a substrate processing apparatus, the experimental data acquirer 261 is an example of an experimental data acquirer, the first compressor 263 is an example of a first compression device, the prediction device is an example of a learning model, and the prediction device generator 265 is an example of a model generator. Further, the information processing apparatus 100 is an example of an information processing apparatus, the variable condition generator 251 is an example of a variable condition generator, the compression device generator 253 is an example of a compression device generator, the second compressor 157 is an example of a second compression device, the nozzle 311 is an example of a nozzle that supplies a processing liquid to a substrate, the nozzle moving mechanism 301 is an example of a mover, and the predictor 159, the evaluator 161 and the processing condition determiner 151 are examples of a processing condition determiner.

## Claims

1. A training device comprising:
an experimental data acquirer that acquires a processing amount indicating a difference between a film thickness obtained before a process and a film thickness obtained after the process in regard to a film formed on a substrate, after a substrate processing apparatus is driven according to processing conditions including a variable condition that varies over time, the substrate processing apparatus processing the substrate by supplying a processing liquid to the substrate on which the film is formed;
a compression device that converts the variable condition such that a dimension count is reduced; and
a model generator that generates a learning model, which executes machine learning using training data and predicts a processing amount indicating a difference between a film thickness obtained before a process and a film thickness obtained after the process in regard to a film formed on a substrate before being processed by the substrate processing apparatus, the training data including a conversion result of the variable condition converted by the compression device, and the processing amount corresponding to the processing conditions.

2. The training device according to claim 1, further comprising:
a variable condition generator that generates a plurality of variable conditions; and
a compression device generator that causes an autoencoder to learn the plurality of variable conditions generated by the variable condition generator and generates the compression device.

3. The training device according to claim 1 or 2, wherein
the processing conditions further include a fixed condition that does not vary over time, and
the training data includes the fixed condition.

4. The training device according to any one of claims 1 to 3, further comprising:
a record acquirer that acquires a processing amount indicating a difference between a film thickness obtained before a process and a film thickness obtained after the process in regard to a film formed on a substrate processed by the substrate processing apparatus, the substrate processing apparatus being driven according to processing conditions including a temporary condition in a case in which a conversion result of the temporary variable condition converted by the compression device is provided to the learning model, and a processing amount predicted by the learning model satisfies an allowable condition; and
an additional trainer that trains the learning model using additional training data that includes a conversion result of the temporary variable condition converted by the compression device, and the processing amount acquired by the record acquirer.

5. The training device according to any one of claims 1 to 4, further comprising a distillater that, in a case in which a conversion result of a temporary variable condition converted by the compression device is provided to the learning model, and a processing amount predicted by the learning model satisfies an allowable condition, generates a new learning model using distillation data including the conversion result and the processing amount predicted by the learning model.

6. The training device according to any one of claims 1 to 5, wherein
the substrate processing apparatus includes
a nozzle that supplies the processing liquid to a substrate, and
a mover that changes relative positions of the nozzle and a substrate with respect to each other, and
the variable condition is relative positions of the nozzle and the substrate changed by the mover.

7. An information processing apparatus that manages a substrate processing apparatus, wherein
the substrate processing apparatus
processes a substrate by supplying a processing liquid to a substrate on which a film is formed according to processing conditions including a variable condition that varies over time, and
includes
a second compression device that converts the variable condition such that a dimension count is reduced, and
a processing condition determiner that determines processing conditions for driving the substrate processing apparatus by using a learning model that predicts a processing amount indicating a difference between a film thickness obtained before a process and a film thickness obtained after the process in regard to a film formed on a substrate before being processed by the substrate processing apparatus,
the learning model is an inference model that has executed machine training using training data, with the training data including a conversion result of a variable condition included in processing conditions according to which the substrate processing apparatus has processed a substrate and converted by a first compression device that is same as the second compression device, and a processing amount indicating a difference between a film thickness obtained before a process and a film thickness obtained after the process in regard to a film formed on the substrate before being processed by the substrate processing apparatus, and
the processing condition determiner, in a case in which a conversion result of a temporary variable condition converted by the second compression device is provided to the learning model, and a processing amount predicted by the learning model satisfies an allowable condition, determines processing conditions including the temporary variable condition as processing conditions for driving the substrate processing apparatus.

8. A substrate processing apparatus including the information processing apparatus according to claim 7.

9. A substrate processing system that manages a substrate processing apparatus processing a substrate, comprising a training device and an information processing apparatus, wherein
the substrate processing apparatus processes a substrate by supplying a processing liquid to a substrate on which a film is formed according to processing conditions including a variable condition that varies over time,
the training device includes
an experimental data acquirer that acquires a processing amount indicating a difference between a film thickness obtained before a process and a film thickness obtained after the process in regard to a film formed on a substrate after the substrate processing apparatus is driven according to the processing conditions,
a first compression device converts the variable condition such that a dimension count is reduced, and
a model generator that generates a learning model, which executes machine learning using training data and predicts a processing amount indicating a difference between a film thickness obtained before a process and a film thickness obtained after the process in regard to a film formed on a substrate before being processed by the substrate processing apparatus, the training data including a conversion result of the variable condition converted by the first compression device, and the processing amount corresponding to the processing conditions,
the information processing apparatus includes
a second compression device that is same as the first compression device, and
a processing condition determiner that determines processing conditions for driving the substrate processing apparatus using the learning model generated by the training device, and
the processing condition determiner, in a case in which a conversion result of a temporary variable condition converted by the second compression device is provided to the learning model, and a processing amount predicted by the learning model satisfies an allowable condition, determines processing conditions including the temporary variable condition as processing conditions for driving the substrate processing apparatus.

10. A training method of causing a computer to execute:
a process of acquiring a processing amount indicating a difference between a film thickness obtained before a process and a film thickness obtained after the process in regard to a film formed on a substrate, after a substrate processing apparatus is driven according to processing conditions including a variable condition that varies over time, the substrate processing apparatus processing the substrate by supplying a processing liquid to the substrate on which the film is formed;
a compression process of converting the variable condition such that a dimension count is reduced; and
a process of generating a learning model, which executes machine learning using training data and predicts a processing amount indicating a difference between a film thickness obtained before a process and a film thickness obtained after the process in regard to a film formed on a substrate before being processed by the substrate processing apparatus, the training data including a conversion result of the variable condition converted in the compression process, and the processing amount corresponding to the processing conditions.

11. A processing condition determining method executed by a computer that manages a substrate processing apparatus, wherein
the substrate processing apparatus processes a substrate by supplying a processing liquid to a substrate on which a film is formed according to processing conditions including a variable condition that varies over time,
the processing condition determining method includes
a process of converting the variable condition such that a dimension count is reduced, and
a process of determining processing conditions for driving the substrate processing apparatus by using a learning model that predicts a processing amount indicating a difference between a film thickness obtained before a process and a film thickness obtained after the process in regard to a film formed on a substrate before being processed by the substrate processing apparatus,
the learning model is an inference model that, in a process same as the process of converting, has executed machine training using training data, with the training data including a conversion result of a variable condition included in processing conditions according to which the substrate processing apparatus has processed a substrate and a processing amount indicating a difference between a film thickness obtained before a process and a film thickness obtained after the process in regard to a film formed on the substrate before being processed by the substrate processing apparatus, and
the process of determining processing conditions includes a process of, in a case in which a conversion result of a temporary variable condition converted in the process of converting is provided to the learning model, and a processing amount predicted by the learning model satisfies an allowable condition, determining processing conditions including the temporary variable condition as processing conditions for driving the substrate processing apparatus.
